# EUROPEAN PATENT APPLICATION

(11) **EP 1 247 872 A1**
(43) Date of publication of application: **09.10.2002**
(21) Application number: 01106087.8
(22) Date of filing: 13.03.2001
(51) Int. Cl.: C22B 9/20, C22C 1/02

(54) **Method for producing metal sputtering target**

(71) Applicant: Solar Applied Material Technology Corp., Erh Chen Village, Kuangtien, Tainan Hsien (TW)
(72) Inventor: Lee, Tsang-Sheau, Taipei (TW); Chen, Jium-Shyong, Taoyuan, Taoyuan Hsien (TW); Yeh, Chien-Hung, Lungtan, Taoyuan Hsien (TW); Chen, Lee-Ho, Yungkang, Tainan Hsien (TW); Chao, Chin-Hsiao, Hsinchu (TW); Chen, Hung-Hua, Yungkang, Tainan Hsien (TW)
(74) Representative: Helms, Joachim, Dipl.-Ing. Patentanwalt

(57) **Abstract**

A method for producing metal sputtering target, comprising a step of double V melting process, and a step of high temperature forging. The step of double V melting process which preferably consists of VIM and VAR produces a single metal of aluminium, titanium, or copper, or an alloy of the single metal associated with at least a different metal selecting from one of copper, silicon, titanium, zirconium, osmium, molybdenum, tungsten, platinium, gold, niobium, tantalum, cobalt, rhenium, and scandium. The step of high temperature forging treats the single metal or the alloy to form the metal sputtering target material with small crystal grains and a secondary phase of fineness and high homogeneity suitable for using in semiconductor and photoelectric industries.

## Description

### BACKGROUND OF THE INVENTION

### 1. Field of The Invention:

The present invention relates to a method for producing metal sputtering target, and particularly to a manufacturing process to make a metal sputtering target having smaller crystal grains with fined and homogenized secondary phase suitable for being used in semiconductor and photoelectric industries.

### 2. Description of Related Art:

The sputtering technique is a film forming technique with which the plasma is utilized to generate ions striking a sputtering target so as to result in atoms of the sputtering target depositing on a substrate as a film surface. The sputtering technique is one of known techniques of sedimentary film forming and has been widely applied to produce a metallic or nonmetallic layer in the manufacturing process needed by the semiconductor and the photoelectric industries. The property of sputtered film tremendously influences the quality of product. A high sputtering velocity during the process and a steady process may provide an advantage of lowering the cost for an economical sized manufacture. These are key factors considered in the process of production. The property of film formed during sputtering is related to the property of the sputtering target itself such as the size of the respective crystal grain and the formation of secondary phase with distribution characteristics.

If the metal sputtering target is made by way of techniques of traditional cast, forming, annealing, and forging, there is a limitation for these techniques to treat the size of crystal grains and the fineness and homogeneity of secondary phase. Although the technique of spray coating can produce relatively smaller size of crystal grains, the equipment and the production costs thereof are too much higher such that it is not suitable for commercialized production of economical size.

### SUMMARY OF THE INVENTION

A primary object of the present invention is to provide a metal sputtering target, which has smaller sized crystal grains with fined and homogenized secondary phase for being possible for commercial application. Thus, a high sputtering velocity and a superior quality of film can be obtained during sputtering.

Another object of the present invention is to provide a metal sputtering target, in which a base material of single metal such as aluminum, titanium, or copper, or of alloy made from the single metal associated with at least one of metals such as copper, silicon, titanium, zirconium, osmium, molybdenum, tungsten, platinum, gold, niobium, tantalum, cobalt, rhenium, and scandium owns a property of smaller sized crystal grains with fined and homogenized secondary phase. Hence, the target made is suitable for the commercialized requirement needed by the semiconductor and the photoelectric industries.

A further object is to provide a method for producing metal sputtering target in which a single metal of aluminum, titanium, or copper, or an alloy of the single metal associated with at least one of other selected metals such as copper, silicon, titanium, zirconium, osmium, molybdenum, tungsten, platinum, gold, niobium, tantalum, cobalt, rhenium, and scandium by way of double V melting process, and the single metal or the alloy is then treated by way of high temperature forging to form the metal sputtering target having smaller crystal grains with fined and homogenized secondary phase. Wherein, the double V melting process comprises a step of vacuum induction melting (VIM) and a step of vacuum arc re-melting (VAR) so it is the reason why the process is called "DOUBLE V MELTING PROCESS" through out the entire specification.

### BRIEF DESCRIPTION OF THE DRAWINGS

The structures, characteristics, and objects of the present invention can be more fully understood by referencing to the following description and accompanying drawings, in which:
Fig. 1 is a microstructure photograph of crystal grains in an aluminum-titanium alloy after single vacuum induction melting;
Fig. 2 is a microstructure photograph of crystal grains in an aluminum-titanium alloy after double V melting process;
Fig. 3 is a microstructure photograph of secondary phase in an aluminum-titanium alloy after the step of single vacuum induction melting;
Fig. 4 is a microstructure photograph of secondary phase in an aluminum-titanium alloy after the double V melting process; and
Fig. 5 is a microstructure photograph of an aluminum-titanium alloy after the double V melting process and the step of high temperature forging.

### DETAILED DESCRIPTION OF THE PREFERRED EMBODIMENTS

The method of producing metal sputtering target has been widely applied in the semiconductor industry and the photoelectric industry to perform the manufacturing process of film sedimentation. The structure of crystal grains and the secondary phase may cause an effect of different sputtering velocity due to different binding energies of base atoms so as to influence the quality of deposited film thereof. It is hard for a conventional cast to proceed for acquiring a much purer metal or an alloy composed of different metals with even ingredients. Further, the conventional cast has its limitation to obtain smaller sized crystal grains with fined and homogenized secondary phase. Hence, the present invention utilizes the technique of single vacuum induction melting (VIM) to produce a single metal or an alloy composed of the single metal and other added different metals. However, the single VIM is still affected by the feature of natural condensation resided in the conventional cast such that it is unable to form finer crystal grains. Moreover, a problem of over sized secondary phase with an uneven distribution may cause due to a greater velocity of condensation.

Accordingly, the preceding single metal or the alloy made of the single metal being added with other different metals through the VIM is treated by way of the vacuum arc re-melting (VAR). Thus, crystal grains with desirable size and the secondary phase with fineness and homogeneity can be reached apparently. The VAR is a melting method with which a single metal or an alloy is melted locally and then solidified again by way of electric arc re-melting in a water cooled crucible under an environment of vacuum so as to form a highly homogenized single metal or alloy. The step of re-melting is that a work piece of single metal or alloy is acted as an electrode and a high current source is applied between the electrode and a conductive crucible so as to induce an electric arc. Then, the electric arc melts the electrode and the molten piece falls down to the water cooled crucible for solidification. Hence, the double V melting process of present invention is that the single metal or the alloy is treated via the step of VIM first and then via the step of VAR. That is, the single metal such as aluminum, titanium, or copper, or the alloy of the single metal associated with at least one of copper, silicon, titanium, zirconium, osmium, molybdenum, tungsten, platinum, gold, niobium, tantalum, cobalt, rhenium, and scandium made by way of the preceding process of double V melting can result in crystal grains with desirable size and the secondary phase with fineness and homogeneity apparently.

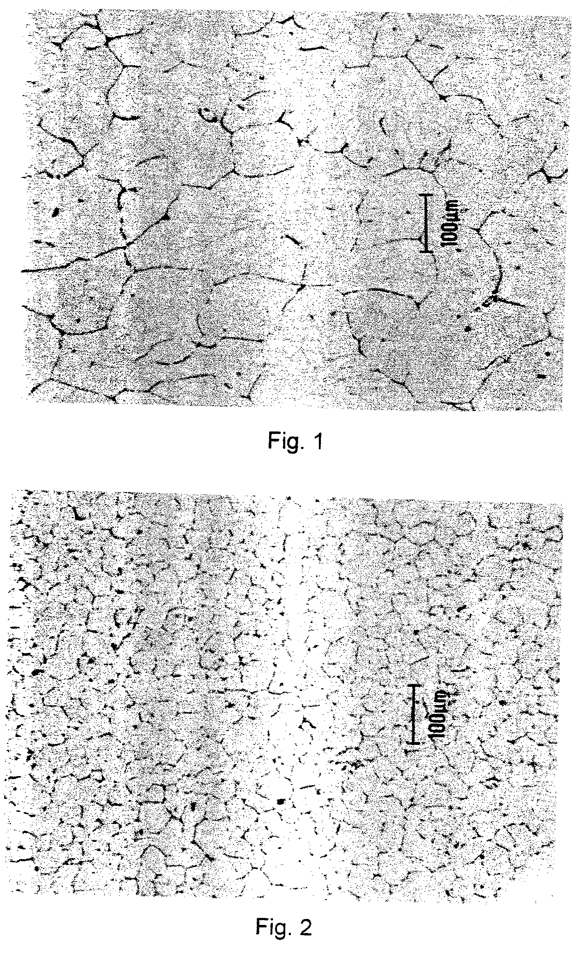

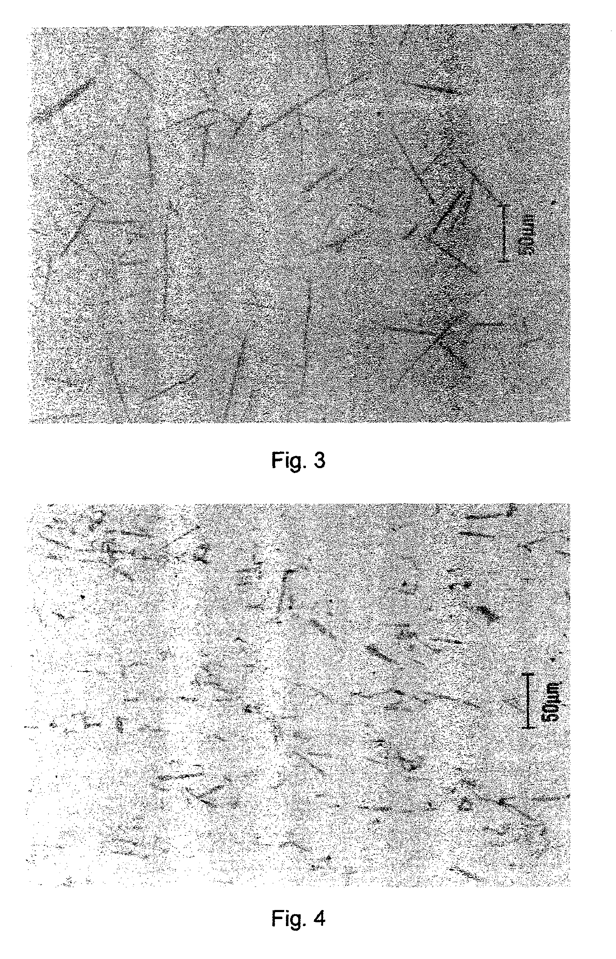

Hereinafter, the aluminum-titanium alloy is taken as an explanatory example. Referring to Figs. 1 and 2, it can be seen apparently that crystal grains in the microstructure photo after being treated by the double V melting process shown in Fig. 2 is approximately 30 µm smaller than that only treated by the VIM shown in Fig. 1. Obviously, the crystal grain treated by way of the double V melting process is much finer than that only treated by the VIM. Referring to Figs. 3 and 4, the secondary phase formed by way of adding titanium to aluminum after the double V melting process shown in Fig. 4 is approximately 20 µm smaller and more homogeneous than that only treated by way of the VIM. This comparison further verifies a better fineness and homogeneity can be obtained for the alloy through the treatment of double V melting process instead of the treatment of the VIM. Moreover, the type and the amount of the added different metals may be variable based on different applications. For instance, it is preferable that the other metal content of the aluminum alloy, in which aluminum is base material, is less than 10% such that the quality and the cost are measurable.

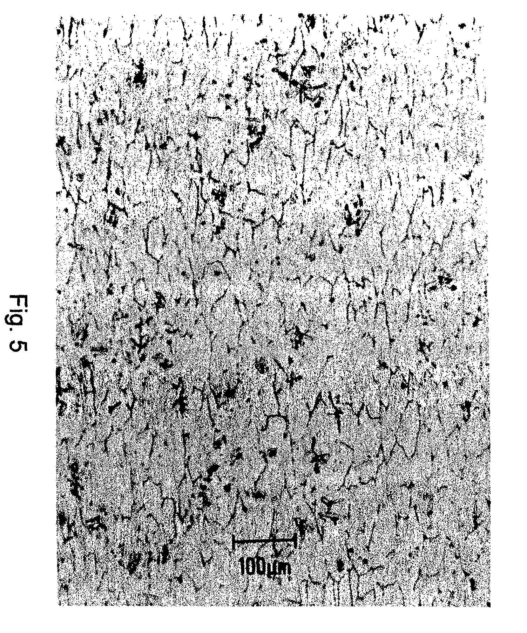

The photograph shown in Fig. 5 illustrates a microstructure of the aluminum-titanium alloy after double V melting process is then treated by way of high temperature forging. It can be seen that the microstructure is still kept fine and homogeneous without change.

Nevertheless, the aluminum-titanium alloy is one of alloys for making metal sputtering target through double V melting process and the step of high temperature forging. Actually, there are many other metallic alloys are suitable for making metal sputtering target material as well. Therefore, a single metal such as aluminum, titanium, or copper, or an alloy composed of the single metal and other metals such as copper, silicon, titanium, zirconium, osmium, molybdenum, tungsten, platinum, gold, niobium, tantalum, cobalt, rhenium, and scandium are base materials for making metal sputtering target by way of preceding manufacturing process. Thus, a metal sputtering target material having smaller sized crystal grains with fined and homogenized secondary phase can be formed for commercial application substantially. Accordingly, the metal sputtering target made by way of the present invention can enhance a high sputtering velocity and superior film quality during sputtering precisely.

It can be understood from the preceding description of embodiment that the present invention is a method to produce a single metal of aluminum, titanium, or copper, or an alloy of the single metal associated with at least a different metal selecting from one of copper, silicon, titanium, zirconium, osmium, molybdenum, tungsten, platinum, gold, niobium, tantalum, cobalt, rhenium, and scandium by way of double V melting processes including VIM and VAR. Furthermore, the metal or the alloy after the double V melting process is then treated by way of the step of high temperature forging. Thus, a metal sputtering target with fineness and high homogeneity can be formed for being suitable for using in the semiconductor and the photoelectric industries. Therefore, the present invention is a novel manufacturing process for metal sputtering target material never seen before.

While the invention has been described with reference to preferred embodiment thereof, it is to be understood that modifications or variations may be easily made without departing from the spirit of this invention, which is defined by the appended claims.

## Claims

1. A method for making metal sputtering target material, comprising
a step of double V melting process, producing a single metal of aluminum, titanium, or copper, or an alloy of the single metal associated with at least a different metal selecting from one of copper, silicon, titanium, zirconium, osmium, molybdenum, tungsten, platinum, gold, niobium, tantalum, cobalt, rhenium, and scandium; and
a step of high temperature forging, treating said single metal or said alloy to form the metal sputtering target material with small crystal grains thereof and a secondary phase of fineness and high homogeneity.

2. The method for making metal sputtering target material according to claim 1, wherein the single metal is a single aluminum and the alloy is an aluminum alloy composed of the single aluminum and at least a different metal selected from one of copper, silicon, titanium, zirconium, osmium, molybdenum, tungsten, platinum, gold, niobium, tantalum, cobalt, rhenium, and scandium.

3. The method for making metal sputtering target material according to claim 2, wherein the other metals content of said aluminum alloy is less than 10%.

4. The method for making metal sputtering target material according to claim 1, wherein said double V process further comprises a step of vacuum induction melting and a step of vacuum arc re-melting.

5. The method for making metal sputtering target material according to claim 2, wherein a secondary phase formed in the metal sputtering target material of aluminum-titanium has a size less than 20 micrometers.

6. The method for making metal sputtering target material according to claim 2, wherein each of crystal grains formed in the metal sputtering target material of aluminum-titanium has a size less than 30 micrometers.

7. A method for making metal sputtering target material, comprising
a step of double V melting process, producing a single metal of aluminum, titanium, or copper, or an alloy block casting of the single metal associated with at least a different metal selecting from one of copper, silicon, titanium, zirconium, osmium, molybdenum, tungsten, platinum, gold, niobium, tantalum, cobalt, rhenium, and scandium; and
a step of high temperature forging, treating said single metal or said alloy block casting to form the metal sputtering target material with small crystal grains thereof and a secondary phase of fineness and high homogeneity.

8. The method for making metal sputtering target material according to claim 7, wherein the single metal is a single aluminum and the alloy block casting is an aluminum alloy composed of the single aluminum and at least a different metal selecting from one of copper, silicon, titanium, zirconium, osmium, molybdenum, tungsten, platinum, gold, niobium, tantalum, cobalt, rhenium, and scandium.

9. The method for making metal sputtering target material according to claim 7, wherein the other metals content of said aluminum alloy is less than 10%.

10. The method for making metal sputtering target material according to claim 7, wherein said double V process further comprises a step of vacuum induction melting and a step of vacuum arc re-melting.

11. The method for making metal sputtering target material according to claim 7, wherein a secondary phase formed in the metal sputtering target material of aluminum-titanium has a size less than 20 micrometers.

12. The method for making metal sputtering target material according to claim 7, wherein each of crystal grains formed in the metal sputtering target material of aluminum-titanium has a size less than 30 micrometers.
